# EUROPEAN PATENT SPECIFICATION

(11) **EP 3 552 299 B1**
(45) Date of publication and mention of the grant of the patent: **09.12.2020**
(21) Application number: 17817899.2
(22) Date of filing: 07.12.2017
(51) Int. Cl.: H02J 50/30, H02J 50/27, H01L 31/09, B82Y 20/00, G02B 5/00

(54) **A PLASMONIC MULTI-TIP NANO-RECTENNA CELL**
PLASMONISCHE MEHRSPITZEN-NANO-RECTENNA-ZELLE
CELLULE D'ANTENNE REDRESSEUSE NANO À POINTES MULTIPLES PLASMONIQUES

(30) Priority: 09.12.2016 IT 201600124680
(43) Date of publication of application: 16.10.2019
(73) Proprietor: Fondazione Istituto Italiano di Tecnologia, 16163 Genova (IT)
(72) Inventor: PROIETTI ZACCARIA, Remo, 16014 Ceranesi (Genova) (IT); TANTUSSI, Francesco, 56021 Cascina (Pisa) (IT); MUPPARAPU, Rajeshkumar, 07747 Jena (DE); JACASSI, Andrea, 16146 Genova (IT); DE ANGELIS, Francesco, 16167 Genova (IT); CUNHA, Joao, Zhejiang 315201 (CN); SUMMERER, Leopold, 2312 GS Leiden (NL)
(74) Representative: Vanzini, Christian
(86) International application number: PCT/IB2017/057716
(87) International publication number: WO 2018/104898

(56) References cited:
- US-A1- 2009 308 443
- US-A1- 2011 100 440
- US-A1- 2011 163 920

## Description

The proposed invention relates to the field of rectification of electromagnetic radiation in the infrared to visible light frequencies using a rectifying antenna (rectenna) approach, which is based on plasmonic antennas and ultrafast tunnelling diodes. The invention finds application in the fields of wideband detection, communication, energy conversion and power harvesting.

Light rectification means addressing the conversion of an electromagnetic wave into DC electricity. A rectenna couples electromagnetic radiation inducing an oscillating (AC) electric signal that is rectified by a diode into DC current. This approach has been demonstrated and used in some parts of the electromagnetic spectrum, namely in the microwave range. Rectennas in the higher energy parts of the spectrum, such as infrared and visible light, pose unique challenges for both the antenna and the diode. Namely in the visible range, one of the major challenges is that the diode has to be able to work at hundreds of THz frequencies.

The Metal-Insulator-Metal (MIM) diode, operating based on quantum tunnelling, is the strongest candidate to extend rectification to hundreds of THz. Quantum tunnelling has been reported to be as fast as 1.8 fs allowing petahertz operation, however the working frequency of a MIM diode can be severely limited by its RC constant. The RC constant depends on the geometry and materials that compose the MIM rectifier. In particular, a planar MIM is not suitable for infrared and visible frequencies. Other practical geometries comprise MIM travelling-wave diodes, geometrical constriction diodes and point-contact diodes (sharp-tip or whisker diodes). In particular, point-contact diodes such as sharp-tip geometries, reduce parasitic capacitance due to the smaller contact area, extending the limiting frequency to hundreds of THz. The choice of materials influences critical performance parameters such as the junction asymmetry, the zero bias responsivity and the zero bias resistance, however so far there are not any strong selection criteria concerning the material choice. Parameters such as material work function, electro-affinity and interface stability are believed to play a major role in the MIM time response. The oxide layer is required to be very thin (∼ nm, for measurable tunnelling current) yet high quality and pin-hole free. Simulations using a quantum-mechanical transfer matrix approach showed that rectification in the infrared and visible frequencies should be possible using sharp-tip diodes.

US 8299655 discloses a device for receiving and converting incident radiation into DC current. The technique presented therein is based on a purely sharp geometric property of the antenna tip or other shaped edges such as patch antennas. The sharp tip or edge with the collector anode constitutes a geometrically asymmetric tunnel junction. US 8299655 proposes different embodiments for an optical rectenna. In particular, a thin wire antenna using mCNTs or nanowire arrays is described. The device uses wavelength dependent sized vertical arrays of nanostructures with point contact-like rectifying junctions. The nanowire/mCNT forms a MVM or MIM junction barrier and the charge transport through the barrier is via tunnelling. The problem of limited frequency response of conventional planar MIM diodes (limited by parasitic capacitance effects) is overcome by the use of these point contact nanowires/mCNTs, and their inherent fast response time (i.e. up to a femtosecond).

US 2011/163920 A1, US 2009/308443 A1 and US 2011/100440 A1 disclose devices for receiving and converting incident radiation into DC current according to the preamble to claim 1.

One object of the invention is to provide a device for optical rectification with high rectification efficiency.

A further object is to provide a device for optical rectification with broadband capability.

In view of these objects, the invention proposes a device for receiving and converting incident radiation into DC current, said device having the features of claim 1.

A further object of the invention is a method for fabricating a device for receiving and converting incident radiation into DC current, said method having the features of claim 4.

The invention proposes a device comprising a plurality of tapered, particularly conical tips coated with a plasmonic layer. A top-down fabrication approach permits to precisely align the conical tips (discrepancy in alignment below 1 degree) and to customize their height-to-radius ratio in order to cover the complete range from 400 nm to 1400 nm of the incident radiation.

Further characteristics and advantages of the proposed device and method will be presented in the following detailed description, which refers to the attached drawings, provided purely by way of non-limiting example, in which:
- Figure 1 shows: (a) the circuit diagram of a traditional rectenna; (b) a schematic, perspective view showing a nano-rectenna base element of a device according to the invention;
- Figure 2 shows a schematic, perspective view of a device not according to the invention;
- Figures 3(a)-3(c) show schematic, perspective views of different broadband rectennas configurations;
- Figures 4(a)-4(b) show two examples of multi-stack base-element nano-rectenna cell;
- Figure 5 is a graph showing the IV characteristic of an Au-TiO₂-Ti rectenna in illuminated (wl) and unilluminated (wol) conditions. Incident wavelength 282Thz (1064nm);
- Figure 6 shows the scanning electron microscope (SEM) image of (a) single tip resonant at 1064nm. The tip is fabricated on top of a 5µm high cantilever. The inset shows a tip apex radius of 8nm; (b) 9 rectenna-tips fabricated on a cantilever.

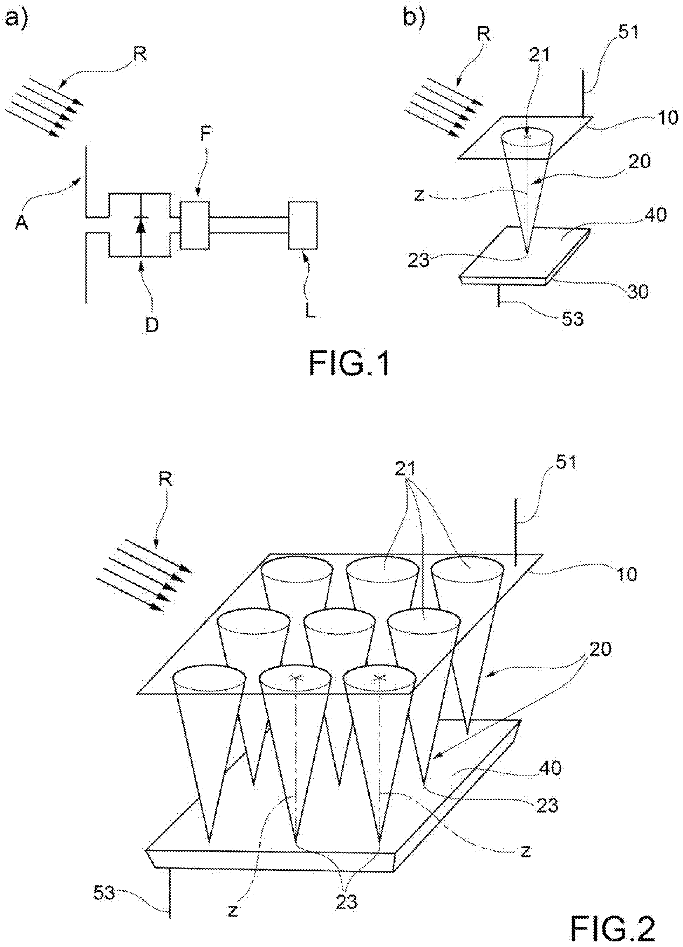

Figure 1(a) shows a traditional rectenna. An antenna A captures electromagnetic radiation R, which can be, for example, solar radiation or laser radiation. Through a connected diode D and DC filter F, the electromagnetic radiation R is converted into DC current and sent towards a load L.

Figure 1(b) shows a nano-rectenna base element. This base element comprises a first conductor 10, and a tapered, particularly conical tip as antenna 20, arranged on the first conductor 10. In the configuration shown in Figure 1(b), the first conductor 10 must be transparent to visible radiation. Therefore, the first conductor may be for example of ITO or graphene. The antenna 20 comprises a circular base 21 arranged on and contacting the first conductor 10, and a sharp apex 23 arranged at a distance from the circular base 23. The apex 23 of the antenna 20 has a radius of few nanometers. A central axis z connecting the apex 23 to the centre of the base 21 is thereby defined. The antenna 20 comprises a solid tapered metallic structure layered on the first conductor 10, and a plasmonic coating layered on the metallic structure. This plasmonic coating cover the lateral surface of the antenna 20, capping its apex 23. The plasmonic coating is of plasmonic metal, i.e. for example Au or Ag.

The nano-rectenna base element further comprises a second conductor 30 arranged in front of the apex 23 of the antenna 20, and an insulating layer 40 layered on the second conductor 30 and interposed between the apex 23 of the antenna 20 and the second conductor 30. The second conductor may be for example of Ti, Al, Ni, Cu, Au, Ag or Pt. The insulating layer 40 may be for example of TiO₂, Al₂O₃, NiO or CuO. A point-contact junction is formed, at which the apex 23 of the antenna 20 contacts the insulating layer 40.

Conducting lines 51 and 53 connects the first and second conductor 10, 30 to a load (not shown).

In the here proposed nano-rectenna approach, the antenna 20 is integrated into the rectifier, being it formed by metal-insulator-metal and based on quantum tunnelling effect.

The conical-like metallic tip 20 functions therefore as antenna, namely has the role of capturing the incident radiation and, at the same time, it dresses the role of one of the metal components in a Metal-Insulator-Metal (MIM) diode.

In terms of dimensions the conical tip length falls in the range from 50nm to 400nm, so to be resonant to the electromagnetic spectrum from 400nm to 1400nm (the most intense part of the radiation spectrum). It is indeed fabricated in accordance to plasmonic resonance simulations to address particular coupling frequencies in this frequency range. The insulating layer 40 shows a thickness from 0.5 to few nanometers, according to the selected material.

Very importantly, the tip apex radius of the metallic antenna 20 has to be as small as possible in order to minimize the associated resistance and capacity which, in turn, means high operation frequency. In the prototypical device, as shown in the following, tip apex radiuses below 10nm were fabricated, and a rectification capability around 300THz (1064nm) was reached. Tests with higher rectification frequency are ongoing, and show preliminary evidence for 384THz (780nm) rectification.

According to an alternative embodiment, the device may be reversed with respect to the configuration shown in Figure 1, i.e. the apex of the antenna 20 may point upwardly and the second conductor with a lower insulating layer may be arranged on top of the antenna.

Figure 2 shows an embodiment not according to the invention in which a plurality of antennas is inserted between a common first conductor and second conductor. Elements corresponding to those shown in Figure 1(b) have been designated with the same reference numbers. In order to increase the net produced current (i.e. power) a matrix of plasmonic conical antennas 20 each with apex radius of the order of few nanometers has to be considered. Once the antenna apexes 23 are put in contact with a thin layer 40 of dielectric material (e.g. TiO₂, Al₂O₃, NiO, CuO) followed by a layer 30 of conductive material (such as Ti, Al, Ni, Cu, Au, Ag, Pt), an extremely fast (up to the hundreds of THz) multi metal-insulator-metal diode can be fabricated. In this manner, the ensemble of antennas 20 can be used to turn the collected solar radiation into DC current. The antennas 20 can be embedded in an optically transparent dielectric matrix for enhanced mechanical stability.

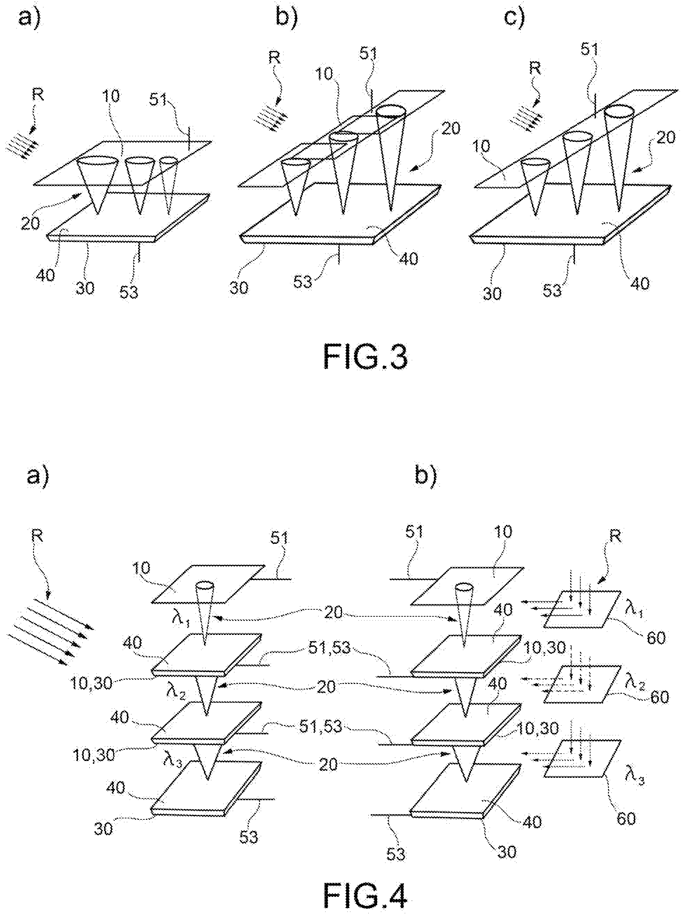

Figure 2 shows indeed the situation where conical structures of the same height are paired to capture the incident radiation. Considering that the height-to-radius ratio (ratio between height of the cone and its base radius) of each conical antenna strongly determines the capturing wavelength range, methods to render the device capable of broadband operational capability are here introduced (see Figure 3, wherein elements corresponding to those shown in Figure 1(b) have been designated with the same reference numbers).

In particular:
a) cones with same height but different base radius: This approach allows for a change of the cones height-to-radius ratio to cover the complete range from 400nm to 1400nm by maintaining electrical contact between antennas 20, insulator 40 and underneath conductor 30 (Fig. 3(a));
b) cones of same base radius and different heights located on a staircase-like first conductor 10 (similar considerations are valid if the stair-case approach is applied to the insulating layer/second conductor 40, 30). Similarly to the previous case, the height-to-radius ratio is modified to embrace all the useful parts of the radiation spectrum. Differently from the technique described in case (a), here the height-to-radius ratio changes because of the different heights (Fig. 3(b));
c) cones of same base radius and different heights located on a sloped first conductor 10 (similar considerations are valid if the slope approach is applied to the insulating layer/second conductor 40, 30). With respect to case (b) here the change in height occurs in a continuous way (Fig. 3(c)).

According to Figure 4, always in the direction of broadband capability, the two-dimensional peculiarity of the devices shown in Figure 3 is extended to the third dimension in a vertically stacked 'sandwich' nano-rectenna (stacked plasmonic elements) according to the invention. Elements corresponding to those shown in Figure 1(b) have been designated with the same reference numbers. In this stack configuration, the second conductor 40 of one of the antennas 20 forms the first conductor 10 of a successive one of the antennas 20. Antennas 20 with different height-to-radius ratios can be envisioned in a stack configuration so to be able to capture all the wavelengths falling in the solar radiation range by using a base-element nano-rectenna of extremely contained dimensions (few hundreds of nm versus some microns for the rectenna base-elements of Figure 3). Figure 4 illustrates the scheme of a multi-stack base-element nano-rectenna device with (b) and without (a) the use of a spectrum splitter. These two methods for multispectral operation of rectennas have similar working to the high-efficiency multispectral semiconductor solar cells. The rectenna method described has the advantage of not requiring material matching for each spectral range, which facilitates integration.

In the two examples of Figure 4 three tips 20 embedded in dielectric layers with different height-to-radius ratios have been considered, each resonating to a specific wavelength (here represented by λ1, λ2 and λ3). Ultra-thin layers of metal (Ti, Al, N or Cu) are introduced as conductors 10, 30 to maximize the transparency towards the incident light. The in-plane dimension of this base element is of the order of 200-500nm. In particular, in (a) incident radiation impinges directly all over the structure. Grazing angle would be preferred in this configuration. In the scheme (b) the concept of spatial spectrum splitting is instead adopted, meaning that upon vertical irradiation the incident spectrum is split into the resonant wavelengths (defined by the height-to-radius ratio of the cones) and directed towards the corresponding antennas 20. In (b) each mirror 60 can reflect only a specific portion of the solar spectrum.

Preliminary data were collected through Atomic Force Microscopy measurements based on a plasmonic nanofabricated tip which can work as an efficient light-coupling antenna and, at the same time, as the upper terminal of a metal-insulator-metal tunnelling diode.

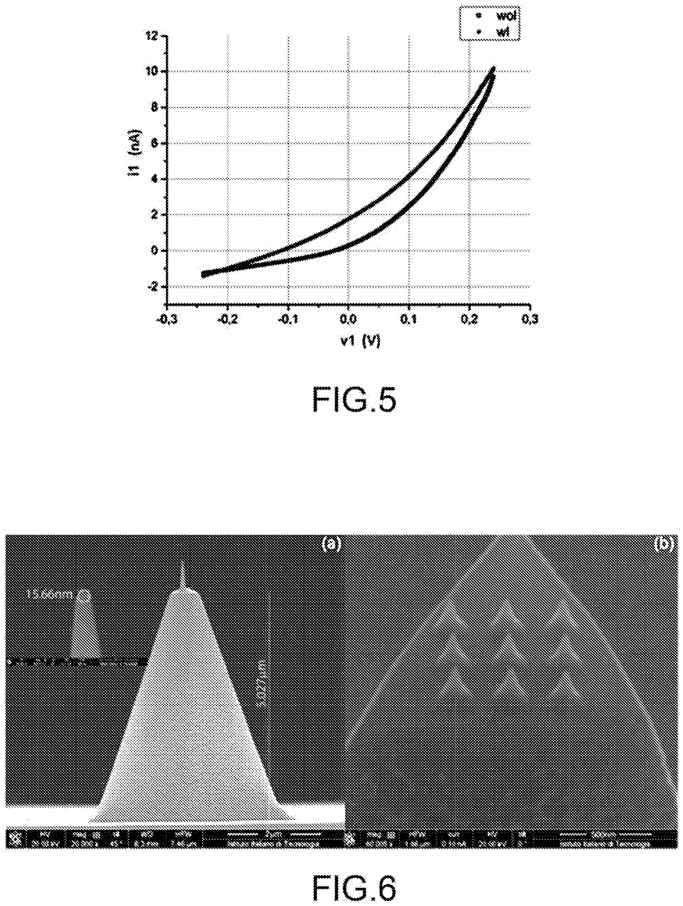

The tip has a conical shape with few nm apex radius (between 6nm and 10nm) and it is several hundred nm height (see Figure 6a). Its plasmonic characteristic is determined by the sputtering/thermal coating/e-beam coating of a plasmonic metal (e.g., Au, Ag) on a geometrically fine dielectric core fabricated through Focus Ion Beam lithography.

For optimal light coupling, two general scenarios are possible: 1) Surface Plasmon-Polariton generation is achieved at the downstream cone through an optimized grating structure. The plasmon polaritons here generated will travel along the cone surface to maximize the field amplitude (i.e. the light intensity) at the tip apex; 2) the cone antenna works close to resonant conditions, hence no grating coupler is needed. For the sake of illustration and proof of concept, the metal-insulator-metal materials used for preliminary tests are Au-TiO₂-Ti, where Au indicates a golden tip. However, different configurations can be considered, such as but not limited to Au-NiO-Ni, Au-CuO-Cu, Au-Al₂O₃-Al. Figure 5 shows the experimental results under light on and off condition (wl=with light, wol=without light) for the Au-TiO₂-Ti configuration and impinging radiation at 282THz (1064nm) when an antenna working in resonant condition was considered. Shining light on the device generates the effect of an extra current, which translates into additional electrical power in a connected load. Importantly, a non-zero current is observed at zero-bias. Ongoing experiments performed with the very same single-tip rectenna device are also suggesting rectification capability at 384THz (780nm), therefore in the visible range.

Another important parameter evaluated in the current experiment is the efficiency of the nano-rectenna. In particular, in order to provide a solid comparative scheme, the same procedure reported in Nature Nanotechnology 10, 1027 (2015) to calculate the rectenna efficiency was followed. When native TiO₂ was utilized as insulator material, the value of the efficiency was 0.0014 for the single nano-rectenna which rose up to 0.0107 for the multi-tip (9 tips) configuration. Remarkably, the best efficiency reported in Nature Nanotechnology 10, 1027 (2015) was of the order of 10⁻⁵. It means that the nano-rectenna here introduced (which is a prototype, therefore sensible improvements are surely possible) can provide an efficiency between 100 (single-rectenna) and 1000 times (multi-rectenna) higher than the value reported in the aforementioned paper.

In the following, some details of the fabrication process of the prototype rectenna are provided:
1) Regarding the tip fabrication:
   - 7nm of Ti and 15nm of Au were deposited on a commercial cantilever through sputter coating;
   - The cantilever is inserted in a Focused Ion Beam (FIB) equipped with a Gas Injection System;
   - The top of the cantilever tip is cut with the ion beam of the FIB in order to realize a flat plateau;
   - On the so created plateau a cone is grown with the Gas Injection System of the FIB;
   - On the cantilever are deposited with the sputter coater between 10nm and 25nm of gold (depending on the objective finesse of the tip);
   - A fast annealing is performed (20min at 190 C);
2) Regarding the insulator/metal fabrication:
   - A fused silica sample is cleaned with a piranha etching;
   - On the fused silica substrate 50nm of titanium are evaporated;
   - Either through spontaneous oxidation or by means of deposition techniques (such as Atomic Layer Deposition) titanium oxide (TiO₂) is developed on top of the Ti surface.

In this way a metal (Au tip)-insulator(TiO₂)-metal (Ti) system is realized on top of fused silica. This system defines a possible choice of rapid rectifier incorporating an antenna device (the tip).
3) Reproduction study:
- Any deposition with sputter coater has a precision of 0.1nm;
- Any deposition with evaporator has a precision of 0.1nm;
- The selection of the region to be cut with the FIB is decided by the user, the magnification used to align the sample with the gallium gun of the FIB is 300000X, fine enough to have a precision of 10nm;
- The cone is created with a Gas Injection System, a platinum carbon gas is fluxed in the microscope chamber, and by the electron beam platinum is deposited exactly in the region shined. This method guarantees to obtain an apex tip below 10nm of diameter with a precision below 2nm. Furthermore, when a series of cones are fabricated, discrepancy in their alignment can be kept below 1 degree.

In preliminary experiments the choice of a single plasmonic sharp-tip geometry mounted on AFM cantilever was determined by the requirement of versatility to provide a systematic test of materials. Differently from the system used for the measurements illustrated in Figure 5, the invention is however AFM free, hence no mobile parts are considered.

The invention is also characterized by a matrix of tips all working together to maximize the DC current generation. In this regard, Figure 6 shows preliminary results of a series of 9 tips fabricated on top of a cantilever. Experiments testing the scalability of the process from one to a plurality of tips are presently ongoing.

## Claims

1. A device for receiving and converting incident radiation into DC current, said device comprising:
- a plurality of first conductors (10);
- a plurality of tapered antennas (20), each antenna (20) comprising a circular base (21) arranged on the respective first conductor (10) and an apex (23), wherein a central axis (z) connecting the apex (23) to the centre of the base (21) is defined, and wherein each of said antennas comprises a solid, tapered metallic structure arranged on, and protruding from, the respective first conductor (10), and a plasmonic coating layered on the metallic structure;
- a plurality of second conductors (30) arranged in front of the apexes (23) of the antennas (20); and
- a respective insulating layer (40) layered on each of the second conductors (30) and interposed between the apexes (23) of the respective antennas (20) and the respective second conductor (30);
wherein a plurality of point-contact junctions is formed, at which each apex (23) of the antennas (20) contacts the respective insulating layer (40);
wherein the central axes (z) of the antennas (20) are parallel to each other with an error smaller than 1 degree;
**characterized in that** the antennas (20) and respective first and second conductors (10, 30) are arranged in a stacked configuration, the second conductor (30) of at least one of said antennas (20) forming the first conductor (10) of a successive one of said antennas (20).

2. A device according to claim 1, wherein each antenna (20) has a radius smaller than 10nm at its apex (23).

3. A device according to any of the preceding claims, wherein at least two of the antennas (20) have different height to radius ratio.

4. A method for fabricating a device for receiving and converting incident radiation into DC current, said method comprising:
- providing a plurality of first conductors (10);
- providing a plurality of tapered antennas (20), each antenna (20) comprising a circular base (21) arranged on the respective first conductor (10) and an apex (23), wherein a central axis (z) connecting the apex (23) to the centre of the base (21) is defined, and wherein said antenna (20) comprises a solid, tapered metallic structure arranged on, and protruding from, the respective first conductor (10), and a plasmonic coating layered on the metallic structure;
- providing a plurality of second conductors (30) and respective insulating layers (40) layered on each of the second conductors (30);
- arranging the second conductors (30) in front of the apexes (23) of the antennas (20) and interposing the insulating layers (40) between the apexes (23) of the respective antennas (20) and the respective second conductors (30), to form a plurality of point-contact junctions at which the apexes (23) of the antennas (20) contact the respective insulating layer (40);
wherein the central axes (z) of the antennas (20) are caused to be parallel to each other with an error smaller than 1 degree;
**characterized in that** the antennas (20) and respective first and second conductors (10, 30) are arranged in a stacked configuration, the second conductor (30) of at least one of said antennas (20) forming the first conductor (10) of a successive one of said antennas (20).

5. A method according to claim 4, wherein each antenna (20) is caused to have a radius smaller than 10nm at its apex (23).

6. A method according to clam 4 or 5, wherein providing the plurality of first conductors (10) includes:
- cutting at least one surface of the plurality of first conductors (10) with a focused ion beam to create at least one flat plateau.

7. A method according to claim 6, wherein providing the plurality of tapered antennas (20) includes:
- growing the tapered metallic structures on the at least one flat plateau by deposition from a precursor gas induced by an electron beam; and
- layering the plasmonic coating on each of the metallic structures.

## Patentansprüche

1. Vorrichtung zum Aufnehmen und Umwandeln einfallender Strahlung in Gleichstrom, wobei die Vorrichtung aufweist:
- eine Mehrzahl von ersten Leitern (10);
- eine Mehrzahl von konisch zulaufenden Antennen (20), wobei jede Antenne (20) eine auf dem jeweiligen ersten Leiter (10) angeordnete kreisförmige Basis (21) und einen Scheitel (23) aufweist, wobei eine Zentralachse (z), welche den Scheitel (23) mit der Mitte der Basis (21) verbindet, definiert ist und wobei jede der Antennen eine massive, konisch zulaufende Metallstruktur, die auf dem jeweiligen ersten Leiter (10) angeordnet ist und von diesem hervorragt, und eine plasmonische Schicht auf der Metallstruktur aufweist;
- eine Mehrzahl von zweiten Leitern (30), die vor den Scheiteln (23) der Antennen (20) angeordnet sind; und
- eine jeweilige Isolierschicht (40), die auf einen jeweiligen der zweiten Leiter (30) geschichtet ist und zwischen die Scheitel (23) der jeweiligen Antennen (20) und des jeweiligen zweiten Leiters (30) zwischengesetzt ist;
wobei eine Mehrzahl von Punkt-Kontakt-Verbindungen gebildet ist, an welchen ein jeweiliger Scheitel (23) der Antennen (20) die jeweilige Isolierschicht (40) berührt;
wobei die Zentralachsen (z) der Antennen (20) mit einer Abweichung von weniger als 1 Grad parallel zueinander verlaufen;
**dadurch gekennzeichnet, dass** die Antennen (20) und jeweilige erste und zweite Leiter (10, 30) in einer gestapelten Konfiguration angeordnet sind, wobei der zweite Leiter (30) mindestens einer der Antennen (20) den ersten Leiter (10) einer darauffolgenden der Antennen (20) bildet.

2. Vorrichtung nach Anspruch 1, wobei jede Antenne (20) an ihrem Scheitel (23) einen Radius von weniger als 10 nm aufweist.

3. Vorrichtung nach einem der vorangehenden Ansprüche, wobei mindestens zwei der Antennen (20) ein unterschiedliches Verhältnis von Höhe zu Radius haben.

4. Verfahren zur Herstellung einer Vorrichtung zum Aufnehmen und Umwandeln einfallender Strahlung in Gleichstrom, wobei das Verfahren aufweist:
- Bereitstellen einer Mehrzahl von ersten Leitern (10);
- Bereitstellen einer Mehrzahl von konisch zulaufenden Antennen (20), wobei jede Antenne (20) eine auf dem jeweiligen ersten Leiter (10) angeordnete kreisförmige Basis (21) und einen Scheitel (23) aufweist, wobei eine Zentralachse (z), welche den Scheitel (23) mit der Mitte der Basis (21) verbindet, definiert ist und wobei die Antenne (20) eine massive, konisch zulaufende Metallstruktur, die auf dem jeweiligen ersten Leiter (10) angeordnet ist und von diesem hervorragt, und eine plasmonische Schicht auf der Metallstruktur aufweist;
- Bereitstellen einer Mehrzahl von zweiten Leitern (30) und jeweiligen, auf jedem der zweiten Leiter (30) angeordneten Isolierschichten (40);
- Anordnen der zweiten Leiter (30) vor den Scheiteln (23) der Antennen (20) und Dazwischensetzen der Isolierschichten (40) zwischen die Scheitel (23) der jeweiligen Antennen (20) und der jeweiligen zweiten Leiter (30), um eine Mehrzahl von Punkt-Kontakt-Verbindungen zu bilden, an welchen die Scheitel (23) der Antennen (20) die jeweilige Isolierschicht (40) berühren;
wobei die Zentralachsen (z) der Antennen (20) mit einer Abweichung von weniger als 1 Grad parallel zueinander verlaufen;
**dadurch gekennzeichnet, dass** die Antennen (20) und jeweilige erste und zweite Leiter (10, 30) in einer gestapelten Konfiguration angeordnet sind, wobei der zweite Leiter (30) mindestens einer der Antennen (20) den ersten Leiter (10) einer darauffolgenden der Antennen (20) bildet.

5. Verfahren nach Anspruch 4, wobei jede Antenne (20) an ihrem Scheitel (23) einen Radius von weniger als 10 nm haben soll.

6. Verfahren nach Anspruch 4 oder 5, wobei das Bereitstellen der Mehrzahl von ersten Leitern (10) beinhaltet:
- Schneiden mindestens einer Oberfläche der Mehrzahl von ersten Leitern (10) mit einem fokussierten lonenstrahl, um mindestens ein flaches Plateau zu erzeugen.

7. Verfahren nach Anspruch 6, wobei das Bereitstellen der Mehrzahl von konisch zulaufenden Antennen (20) beinhaltet:
- Wachsenlassen der konisch zulaufenden Metallstrukturen auf dem mindestens einen flachen Plateau durch Abscheidung aus einem durch einen Elektronenstrahl induzierten Vorläufergas; und
- Schichten der plasmonischen Schicht auf jede der Metallstrukturen.

## Revendications

1. Dispositif de réception et de conversion de rayonnement incident en courant continu, ledit dispositif comprenant :
- une pluralité de premiers conducteurs (10) ;
- une pluralité d'antennes effilées (20), chaque antenne (20) comprenant une base circulaire (21) agencée sur le premier conducteur (10) respectif et un sommet (23), dans lequel un axe central (z) reliant le sommet (23) au centre de la base (21) est défini, et dans lequel chacune desdites antennes comprend une structure métallique effilée pleine agencée sur le premier conducteur (10) respectif et en saillie depuis celui-ci, et un revêtement plasmonique disposé en couche sur la structure métallique ;
- une pluralité de seconds conducteurs (30) agencés devant les sommets (23) des antennes (20) ; et
- une couche isolante (40) respective disposée en couche sur chacun des seconds conducteurs (30) et interposée entre les sommets (23) des antennes (20) respectives et le second conducteur (30) respectif ;
dans lequel une pluralité de jonctions à contact par pointe est formée, au niveau de laquelle chaque sommet (23) des antennes (20) entre en contact avec la couche isolante (40) respective ;
dans lequel les axes centraux (z) des antennes (20) sont parallèles les uns aux autres avec une erreur inférieure à 1 degré ;
**caractérisé en ce que** les antennes (20) et les premiers et seconds conducteurs (10, 30) respectifs sont agencés dans une configuration empilée, le second conducteur (30) d'au moins l'une desdites antennes (20) formant le premier conducteur (10) d'une antenne successive desdites antennes (20).

2. Dispositif selon la revendication 1, dans lequel chaque antenne (20) a un rayon inférieur à 10 nm au niveau de son sommet (23).

3. Dispositif selon l'une quelconque des revendications précédentes, dans lequel au moins deux des antennes (20) ont un rapport hauteur sur rayon différent.

4. Procédé de fabrication d'un dispositif de réception et de conversion de rayonnement incident en courant continu, ledit procédé comprenant :
- la fourniture d'une pluralité de premiers conducteurs (10) ;
- la fourniture d'une pluralité d'antennes effilées (20), chaque antenne (20) comprenant une base circulaire (21) agencée sur le premier conducteur (10) respectif et un sommet (23), dans lequel un axe central (z) reliant le sommet (23) au centre de la base (21) est défini, et dans lequel ladite antenne (20) comprend une structure métallique effilée pleine agencée sur le premier conducteur (10) respectif, et en saillie depuis celui-ci, et un revêtement plasmonique disposé en couche sur la structure métallique ;
- la fourniture d'une pluralité de seconds conducteurs (30) et de couches isolantes (40) respectives disposées en couche sur chacun de seconds conducteurs (30) ;
- l'agencement de seconds conducteurs (30) devant les sommets (23) des antennes (20) et l'interposition des couches isolantes (40) entre les sommets (23) des antennes (20) respectives et les seconds conducteurs (30) respectifs, pour former une pluralité de jonctions à contact par pointe au niveau de laquelle les sommets (23) des antennes (20) entrent en contact avec la couche isolante (40) respective ;
dans lequel les axes centraux (z) des antennes (20) sont amenés à être parallèles les uns aux autres avec une erreur inférieure à 1 degré ;
**caractérisé en ce que** les antennes (20) et les premiers et seconds conducteurs (10, 30) respectifs sont agencés dans une configuration empilée, le second conducteur (30) d'au moins l'une lesdites antennes (20) formant le premier conducteur (10) d'une antenne successive desdites antennes (20).

5. Procédé selon la revendication 4, dans lequel chaque antenne (20) est amenée à avoir un rayon inférieur à 10 nm au niveau de son sommet (23).

6. Procédé selon la revendication 4 ou 5, dans lequel la fourniture de la pluralité de premiers conducteurs (10) comporte :
- la coupe d'au moins une surface de la pluralité de premiers conducteurs (10) avec un faisceau ionique focalisé pour créer au moins un plateau plat.

7. Procédé selon la revendication 6, dans lequel la fourniture de la pluralité d'antennes effilées (20) comporte :
- la croissance des structures métalliques effilées sur l'au moins un plateau plat par dépôt à partir d'un gaz précurseur induit par un faisceau électronique ; et
- la disposition en couche du revêtement plasmonique sur chacune des structures métalliques.
